# EUROPEAN PATENT APPLICATION

(11) **EP 4 718 727 A1**
(43) Date of publication of application: **01.04.2026**
(21) Application number: 25200358.7
(22) Date of filing: 04.09.2025
(51) Int. Cl.: H03K 19/0175, H03K 19/0185

(54) **NON-LINEAR FLOATING RAIL GENERATION**

(30) Priority: 25.09.2024 US 202418896527
(71) Applicant: STMicroelectronics International N.V., 1228 Plan-les-Ouates, Geneva (CH)
(72) Inventor: Shashwat, 201010 Kaushambi (IN); SAINI, Pravesh Kumar, 201310 Greater Noida, Uttar Pradesh (IN)
(74) Representative: Buzzi, Notaro & Antonielli d'Oulx S.p.A.

(57) **Abstract**

A method (1000), comprising: generating (1002) a range selection signal based on a comparison of a supply voltage to a threshold voltage; receiving (1004), with a floating ground generation circuit, the range selection signal; outputting (1006), with the floating ground generation circuit, either ground or a first divided voltage as a ground voltage based on a value of the range selection signal; receiving (1008), with a floating supply generation circuit, the range selection signal; and outputting (1010), with the floating supply generation circuit, either the supply voltage or a second divided voltage as a high supply voltage based on the value of the range selection signal.

An integrated circuit includes a floating rail voltage generator configured to receive a supply voltage and ground and to generate a non-linear floating supply voltage and a non-linear floating ground voltage based on a range selection signal. The integrated circuit includes a range selection generator that generates the range selection signal based on a comparison between the supply voltage and a threshold voltage.

## Description

### BACKGROUND

### Technical Field

This present disclosure is related to computer memory, and more particularly, to write operations of computer memories.

### Description of the Related Art

In integrated circuit technology, there is a demand for circuits and systems that support high voltage ranges using low voltage tolerant transistors. In systems-on-chip (SoC), the switch mode power supply (SMPS) input/output (I/O) circuitry may be utilized as part of SMPS DC-DC converters. This can enable interfacing of on-chip SMPS circuits with external components like power PMOS and NMOS with correct voltage levels. It can be beneficial to separate the supply of SMPS being shared with other analog blocks like phase-locked loops (PLL), analog-to-digital converters (ADC) etc. for noise isolation. This may call for the SMPS to work on a pre-regulated supply which is normally higher than the reliability limits of the devices used. This may call for a design that can reliably operate with higher supply voltages without hitting the SOA limits of the devices. Linear regulators may be placed on pre-regulated supplies to drive the analog blocks, while SMPS may drive the SoC core supply voltage.

However, there are various drawbacks and difficulties associated with these systems. For example, elevated voltage operation of MOSFETs may call for cascading of devices to mitigate reliability issues. Cascode bias may be generated through closed loops, which may lead to stability issues. Large off-chip gate-capacitors of external MOSFETs may call for large drivers which, in turn, calls for large bandwidth of loops, thereby further complicating stability problems. These systems may call for support of large transient currents during switching of driver outputs. Also, there may be a large dynamic range of operation of input supply.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventor's approach to the particular problem, which, in and of itself, may also be inventive.

### BRIEF SUMMARY

Embodiments of the present disclosure provide circuitry that overcome at least some of the drawbacks of previous solutions. Embodiments of the present disclosure generate effective mid rail voltages that can be used as floating supply and floating ground rails for driving external circuitry via an I/O pad. The floating supply and floating ground voltages are supplied to a P-driver and an N-driver in order to drive the I/O pad.

Embodiments of the present disclosure generate nonlinear floating supply and floating ground voltages. Embodiments of the present disclosure include a floating supply generation circuit, a floating ground generation circuit, and a range selection generation circuit. The range selection generation circuit receives the regulated supply voltage and ground and generates a range selection signal based on the supply voltage. The range selection signal is provided as a control signal to the floating supply generation circuit and the floating ground generation circuit. The floating supply generation circuit outputs either the supply voltage or a divided supply voltage based on range selection signal. The floating ground generation circuit outputs either ground or a divided low supply signal based on the range selection signal.

In one embodiment, a method includes generating a range selection signal based on a comparison of a supply voltage to a threshold voltage, receiving, with a floating ground generation circuit, the range selection signal, and outputting, with the floating ground generation circuit, either ground or a first divided voltage as a ground voltage based on a value of the range selection signal. The method includes receiving, with a floating supply generation circuit, the range selection signal and outputting, with the floating supply generation circuit, either the supply voltage or a second divided voltage as a high supply voltage based on the value of the range selection signal.

In one embodiment, an integrated circuit includes a range selection generator configured to generate a range selection signal based on a magnitude of a supply voltage. The integrated circuit includes a floating ground generation circuit configured to receive the range selection signal and to output a floating ground voltage having a value of either ground or a first divided voltage greater than ground based on the range selection signal. The integrated circuit includes a first driver configured to receive the floating ground voltage at a low supply terminal.

In one embodiment, an integrated circuit includes a floating rail generation circuit. The floating rail generation circuit includes a first range selection transistor configured to receive, on a gate terminal a range selection signal and a second range selection transistor configured to receive, on a gate terminal, the range selection signal. The floating rail generation circuit includes a first floating voltage node coupled between a first voltage rail and a second voltage rail and configured to output, as a first floating rail voltage, either the first floating voltage rail or a divided voltage having a value between the first and second voltage rails based on the range selection signal.

### BRIEF DESCRIPTION OF THE SEVERAL VIEWS OF THE DRAWINGS

Figure 1 is a diagram exemplary of an integrated circuit including a floating rail generation circuit, in accordance with one embodiment.
Figure 2 is a diagram exemplary of a floating ground generation circuit, in accordance with one embodiment.
Figure 3 is a diagram exemplary of a floating ground generation circuit, in accordance with one embodiment.
Figure 4 is a diagram exemplary of a floating ground generation circuit, in accordance with one embodiment.
Figure 5 is a diagram exemplary of a floating supply generation circuit, in accordance with one embodiment.
Figure 6 is a diagram exemplary of a floating supply generation circuit, in accordance with one embodiment.
Figure 7 is a diagram exemplary of a floating supply generation circuit, in accordance with one embodiment.
Figure 8 is a diagram exemplary of a range selection circuit, in accordance with one embodiment.
Figure 9 includes exemplary graphs related to generation of floating rail voltages, in accordance with one embodiment.
Figure 10 is a flow diagram exemplary of a method for generating floating supply and floating ground voltages, in accordance with some embodiments.

### DETAILED DESCRIPTION

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known algorithms associated with facial recognition, facial detection, and facial authentication have not been shown or described in detail, to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to." Further, the terms "first," "second," and similar indicators of sequence are to be construed as interchangeable unless the context clearly dictates otherwise.

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

As used herein, "source/drain terminal" can refer to a source terminal of a transistor or a drain terminal of a transistor.

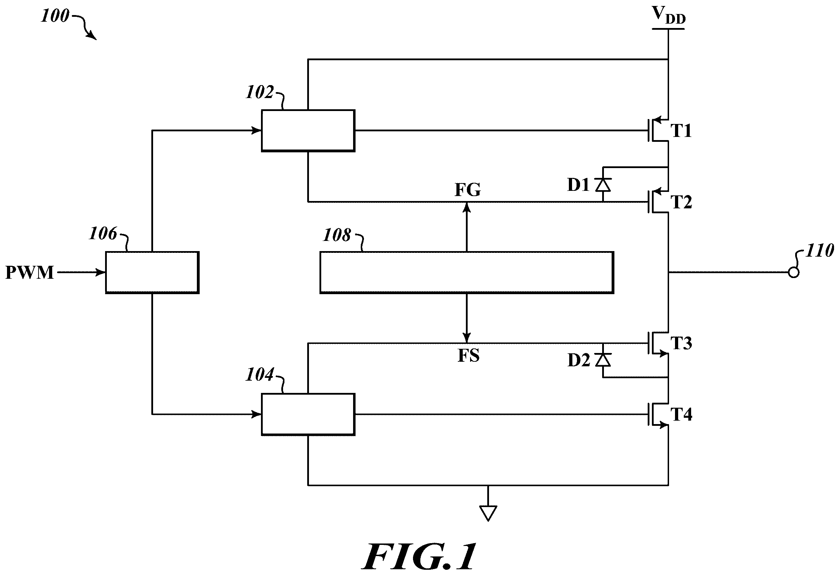

Figure 1 is a diagram exemplary of an integrated circuit 100, in accordance with some embodiments. The integrated circuit 100 includes a P-driver 102, an N-driver 104, and a floating rail generation circuit 108. As discussed in the following, the components of the integrated circuit 100 cooperate to effectively and efficiently generate nonlinear floating rail voltages to assist in driving an I/O pad 110 of the integrated circuit 100.

The integrated circuit includes P-type transistors T1 and T2 coupled between the supply voltage VDD and the I/O terminal 110. The source terminal of the transistor T1 is coupled to VDD, the gate terminal is coupled to the output of the P-driver 102, and the drain terminal coupled to the source terminal of the transistor T2. The gate terminal of the transistor T2 receives the floating ground voltage FG, and the drain terminal is coupled to the I/O terminal 110. The drain terminal of the transistor T3 is coupled to the I/O terminal 110, the gate terminal receives the floating supply voltage FS, and the source terminals coupled to the drain terminal of the transistor T4. The gate terminal of the transistor T4 receives the output of the N-driver 104. The source terminal of the transistor T4 is coupled to ground. A diode D1 is coupled between the gate terminal of the transistor T2 and the source terminal of the transistor T2. A diode D2 is coupled between the source terminal of the transistor T3 and the gate terminal of the transistor T3.

The integrated circuit 100 includes a circuit 106 that supplies control signals to the P-driver 102 and the N-driver 104. More particularly, the circuit 106 receives the pulse width modulated (PWM) signal and provides the control signals to the drivers 102 and 104 based on the PWM signal.

In one embodiment, the circuit 106 is a circuit that prevents overlap between the control signals sent to the P-driver 102 and the control signals sent to the N-driver 104. In practice, the P-driver drives the gate terminal of the transistor T1 to alternate between conducting and non-conducting states. In the conducting state of the transistor T1, VDD is supplied to the I/O terminal 110. The N-driver 104 drives the gate terminal of the transistor T4 to alternate between conducting and non-conducting states. In the conducting state of the transistor T4, ground voltage is applied to the I/O terminal 110. The circuit 106 supplies control signals to the P-driver 102 and the N-driver 104 in a manner that ensures that there is no overlap in the conducting states of the transistors T1 and T4. In other words, the circuit 106 helps to ensure that the transistors T1 and T4 are never conducting at the same time, thereby preventing a short circuit between VDD and ground.

The floating rail generation circuit 108 generates the floating ground voltage FG in a nonlinear manner. In particular, floating ground voltage FG can have one of two values, depending on the value of the supply voltage VDD. The floating rail generation circuit 108 generates floating ground voltage FG as ground if VDD is less than or equal to a range selection voltage. The floating rail generation circuit 108 generates floating ground voltage FG as a first divided voltage if VDD is greater than the range selection voltage. The low divided voltage is higher than ground. In this manner, floating ground voltage FG is nonlinear in that it either has the value of ground or the value of a low divided voltage.

Floating ground voltage FG is provided as the low supply voltage to the P-driver 102. VDD is provided as the high supply voltage to the P-driver 102. The P-driver 102 turns on the transistor T1 by supplying FG to the transistor T1. The P-driver turns off the transistor T1 by supplying VDD to the transistor T1.

Floating ground voltage FG is also provided to the gate terminal of the transistor T2. Accordingly, the transistor T2 is continuously conducting, during standard operation.

The floating rail generation circuit 108 generates the floating supply voltage FS in a nonlinear manner. In particular, floating supply voltage FS can have one of two values, depending on the value of the supply voltage VDD. The floating rail generation circuit 108 generates floating supply voltage FS as VDD if VDD is less than or equal to a range selection voltage. The floating rail generation circuit 108 generates floating supply voltage FS as a high divided voltage if VDD is greater than the range selection voltage. The high divided voltage is less than VDD, but higher than the low divided voltage. In this manner, floating supply voltage FS is nonlinear in that floating supply voltage FS either has the value of VDD or the value of a low divided voltage.

Floating supply voltage FS is provided as the high supply voltage to the N-driver 104. Ground is provided as the low supply voltage to the N-driver 104. The N-driver 104 turns on the transistor T4 by supplying FS to the transistor T4. The N-driver 104 turns off the transistor T4 by supplying ground to the transistor T1.

Floating supply voltage FS is also provided to the gate terminal of the transistor T3. Accordingly, the transistor T3 is continuously conducting, during standard operation.

In one embodiment, the I/O terminal 110 is an I/O pad of the integrated circuit 100. In one embodiment, the I/O pad 110 is utilized to drive the gate terminal of an external power transistor or other device. Accordingly, the floating rail voltages FS and FG can be utilized to drive the gate terminal of the external power transistor or other external device.

As will be described in more detail below, the floating ground generation circuit 108 can include a floating ground generation circuit 109 and a floating supply generation circuit 111. The floating ground generation circuit 109 generates floating ground voltage FG. The floating supply generation circuit 111 generates floating supply voltage FS.

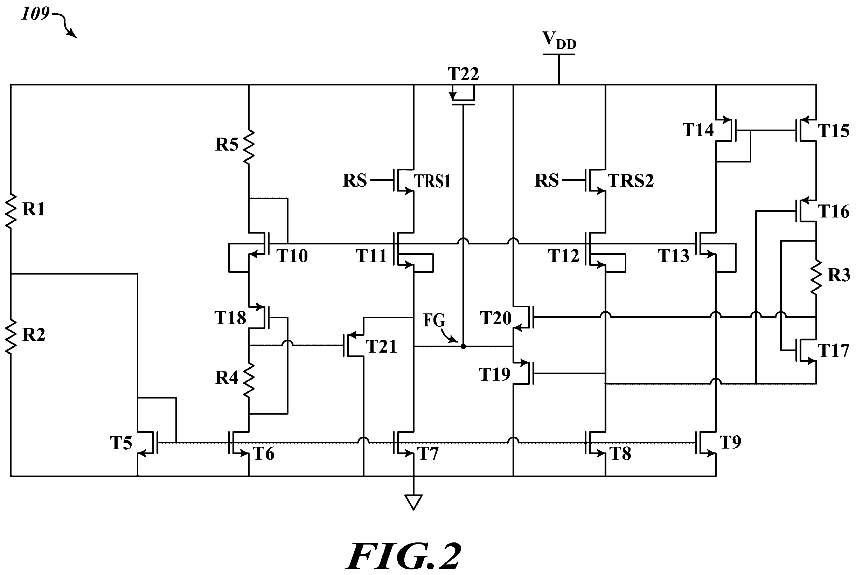

Figure 2 is a diagram exemplary of a floating ground generation circuit 109, in accordance with one embodiment. The floating ground generation circuit 109 can be part of the floating rail generation circuit 108 described in relation to Figure 1. The floating ground generation circuit 109 includes N-type transistors T5-T9 coupled together in a current mirror configuration. More particularly, the transistors T6-T9 drive mirrored currents based on the current to the transistor T5. The gate terminal of the transistor T5 coupled to the drain terminal of the transistor T5. The drain terminal of the transistor T5 is coupled between the resistors R1 and R2. The resistors R1 and R2 are coupled in series between VDD and ground. The resistors R1 and R2 provide a threshold voltage to the drain terminal of the transistor T5. The source terminals of the transistors T5-T9 are coupled to ground. In this manner, the threshold voltage from R1 and R2 drives the current through the transistors T5-T9.

The floating ground generation circuit 109 also includes N-type transistors T10-13, coupled together in a current mirror configuration. The transistor T10, in conjunction with the resistor R5 drives the current through the transistors T10-T13. In one embodiment, the resistor R5 has a value equal to the parallel resistance of R1 and R2. In one embodiment, the resistance of the resistor R5 is a threshold resistance.

The floating ground generation circuit 109 includes P-type transistors T14, T15, and T16, and N-type transistor T17. A resistor R3 is coupled between the drain terminals of the transistors T16 and T17. The source terminal of the transistor T14 is coupled to VDD. The drain terminal of the transistor T14 is coupled to the gate terminal of the transistor T14 and to the drain terminal of the transistor T13. The transistor T14 is coupled in a current mirror configuration with the transistor T15. The transistor T16 has a source terminal coupled to the drain terminal of the transistor T15 and a gate terminal coupled to the source terminal of the transistor T17. The gate terminal of the transistor T17 is coupled to the drain terminal of the transistor T16.

The floating ground generation circuit 109 includes P-type transistors T18, T19, and T21, and N-type transistor T20. The source terminal of the transistor T18 is coupled to the source terminal of the transistor T10. A resistor R4 is coupled between the drain terminals of the transistors T18 and T6. The gate terminal of the transistor T18 is coupled to the drain terminal of the transistor T6. The source terminal of the transistor T19 is coupled to the source terminal of the transistor T20, the gate terminal is coupled to the source terminal of the transistor T17, and the drain terminal is coupled to ground. The drain terminal of the transistor T20 is coupled to VDD and the gate terminal is coupled to the drain terminal of the transistor T17. The drain terminal of the transistor T21 is coupled to the source terminal of the transistor T11, the gate terminal is coupled to the drain terminal of the transistor T18, and the source terminal is coupled to ground.

The floating ground generation circuit 109 includes a P-type transistor T22 having source and drain terminals coupled to VDD and the gate terminal coupled to the node at which FG is generated. Accordingly, the transistor T22 is coupled as a capacitor having a first terminal corresponding to the gate and the second terminal corresponding to the body.

The floating ground voltage FG is generated at a node coupled to the gate terminals of the transistors T19, T20, to the source terminals of the transistors T11 and T21, capacitor coupled transistor T22. Accordingly, the floating ground node is coupled to a gate terminal of both a P-type and an N-type transistor, and to a source terminal of both a P-type and an N-type transistor.

The floating ground generation circuit 109 includes a first range selection transistor TRS1. The first range selection transistor TRS1 is an N-type transistor having a drain terminal coupled to VDD and a source terminal coupled to the drain terminal of the transistor T11. The first range selection transistor TRS1 receives a range selection signal RS on its gate terminal.

The floating ground generation circuit 109 includes a second range selection transistor TRS2. The second range selection transistor TRS2 is an N-type transistor having a drain terminal coupled to VDD and a source terminal coupled to the drain terminal of the transistor T12. The second range selection transistor TRS2 receives the range selection signal RS on its gate terminal.

The value of floating ground voltage FG is based on the range selection signal RS. As will be described further below, the range selection signal RS is based on the value of supply voltage VDD. The effect of the floating ground generation circuit 109 is to generate the floating ground voltage FG as either ground, or a low divided voltage, based on the range selection signal RS. In particular, floating supply voltage FG is equal to ground if VDD is less than a range selection voltage. Floating supply voltage FG is equal to the low divided voltage if VDD is greater than the range selection voltage. As will be described in more detail below, the range selection voltage is a threshold voltage, while the range selection signal RS is a binary signal having either the value of supply voltage VDD or ground.

In one embodiment, the low divided voltage is equal to VDD*((R1/(R1+R2)). Other values of the low divided voltage can be utilized without departing from the scope of the present disclosure.

In one embodiment, the left-hand part of the circuit generates a bias voltage applied to the gate of the transistor T10. More particularly, R1, R2, R4, T5, T6, T18 cooperate to generate the bias voltage at the gate of the transistors T10 and T11, such that the desired FG is generated. In some cases, the voltage at the gates of the transistors T10 and T11 is the sum of FG and the threshold voltage of T11.

The values of the resistors R1 and R2 are selected to provide desired low divided voltage, as described above. The gate voltage of the transistor T5 is based on the values of VDD, R1 and R2. The voltage at the gate of the transistor T5 is the Thevenin voltage Vth = VDD*(R2/((R1+R2). The Thevenin current Ith flowing through T5 is equal to (Vth - Vgs5)/(Rth), where Rth is the Thevenin resistance Rth = (R1*R2)/(R1+R2), and Vgs5 is the gate to source voltage of the transistor T5. This current Ith is driven through T6 via the current mirror configuration. Based on the configuration of the circuit, Ith will flow through T10. Because the value of R5 is selected to be equal to Rth, the Vgs of T10 will be the same as the Vgs of T5 (and T6). Accordingly, the voltage at the source of T10 is VDD - Vth, which is one Vgs less than the voltage at the gates of T10 and T11. Accordingly, the floating ground voltage FG at the source of T11 is equal to the voltage at the source of T10, if TRS1 is conducting. Therefore, when TRS1 is conducting, floating ground voltage FG is equal to VDD - Vth, which is equal to VDD*(R1/(R1+R2)), the low divided voltage set forth above. One example, the low divided voltage is set as one third the value of VDD.

The signal RS is a control signal based on the magnitude of VDD. In one embodiment, RS is designed so that the low divided voltage is provided that FG only when VDD is greater than a selected threshold, such as the safe operating limit of the transistors. Accordingly, in this example, RS is high when VDD is greater than the threshold voltage and FG is the low divided voltage. If VDD is less than the threshold voltage, then FS is low and the transistor TRS1 is off, preventing Ith from flowing through T11. In this case, FG is equal to ground.

The transistors T19-T21 supply currents during transient states. During transient conditions, it is possible for floating ground voltage FG to go higher or lower than desired. T19-T21 are configured so that they are off when floating ground voltage FG is in the desired ranged. However, the transistors T19-T21 are at the edge of conduction such that slight changes in FG can result in conduction of the transistors T19-T21. For example, if FG goes higher than desired, T19 and T21 may act as pull-down transistors that draw FG downward. If floating ground voltage FG goes lower than desired, T20 becomes conducting and acts as a pull-up transistor to raise the voltage of FG. T8, T9, T12-T17, TRS2, and R3 provide the biasing for T19 and T20. In one example, TRS2, T12, and T8 generate a replica voltage at the gate of T19. The transistor T22 is a decoupling capacitor between floating ground voltage FG and the supply.

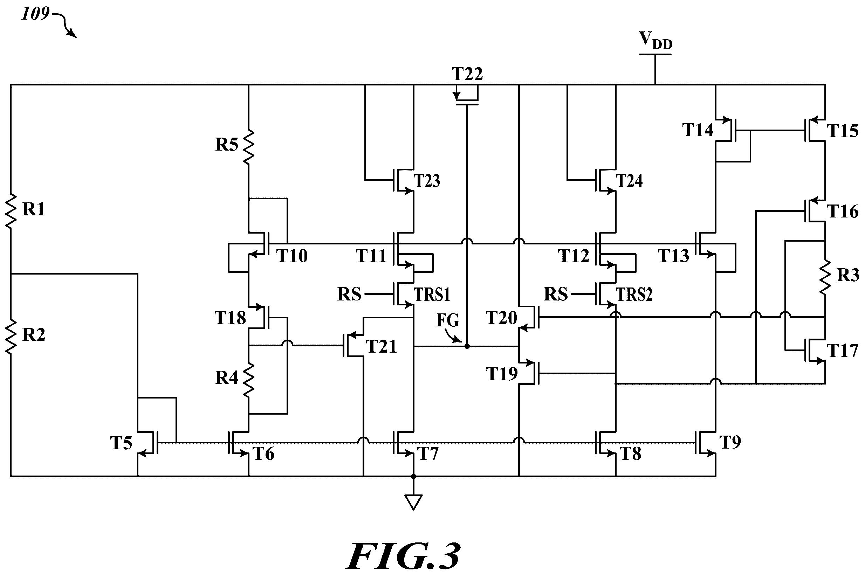

Figure 3 is a schematic diagram of a floating ground generation circuit 109, in accordance with one embodiment. The floating ground generation circuit 109 of Figure 3 is substantially similar to the floating ground generation circuit 109 of Figure 2. However, in Figure 3, the range selection transistor TRS1 has a drain terminal coupled to the source terminal of the transistor T11, and a source terminal coupled to the floating ground node. Accordingly, the floating ground voltage FG is generated at the source terminal of the range selection transistor TRS1. Additionally, the range selection transistor TRS2 has a drain terminal coupled to the source terminal of the transistor T12, and a source terminal coupled to the drain terminal of the transistor T8 and to the gate terminal of the transistor T19.

In Figure 3, an N-type transistor T23 has drain and gate terminals coupled to VDD, and a source terminal coupled to the drain terminal of the transistor T11. An N-type transistor T24 has drain and gate terminals coupled to VDD and a source terminal coupled to the drain terminal of the transistor T12. The effect of the floating ground generation circuit 109 of Figure 3 is to generate the floating ground voltage FG as either ground, or a low divided voltage, based on the range selection signal RS. In particular, FG is equal to ground if VDD is less than a range selection voltage. Floating ground voltage FG is equal to the low divided voltage if VDD is greater than the range selection voltage. The circuit of Figure 3 operates in a substantially similar way as the circuit of Figure 2, except that the transistors TRS 1 and TRS2 are positioned lower in their respective current paths.

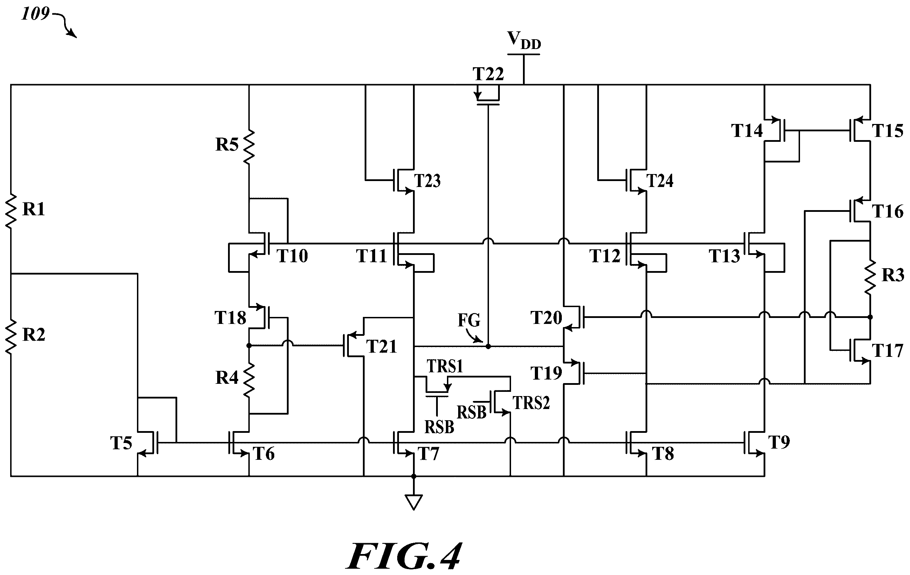

Figure 4 is a diagram exemplary of a floating ground generation circuit 109, in accordance with one embodiment. The floating ground generation circuit 109 of Figure 4 is substantially similar to the floating ground generation circuit 109 of Figure 4. However, in Figure 4, the range selection transistor TRS1 is a P-type transistor having a drain terminal coupled to the source terminal of the transistor T11, and a source terminal coupled to the drain terminal of the TRS2. Additionally, the range selection transistor TRS2 has a drain terminal coupled to the source terminal of the range selection transistor TRS1, and a source terminal coupled to ground. Accordingly, the floating ground voltage FG is generated at the drain terminal of the range selection transistor TRS1. Furthermore, the gate terminals of the range selection transistors TRS1 and TRS2 receive the range selection signal RSB, corresponding to the logical complement of the range selection signal RS.

The effect of the floating ground generation circuit 109 of Figure 4 is to generate the floating ground voltage FG as either ground, or a low divided voltage, based on the range selection signal RSB. In particular, floating ground voltage FG is equal to ground if VDD is less than a range selection voltage. Floating ground voltage FG is equal to the low divided voltage if VDD is greater than the range selection voltage.

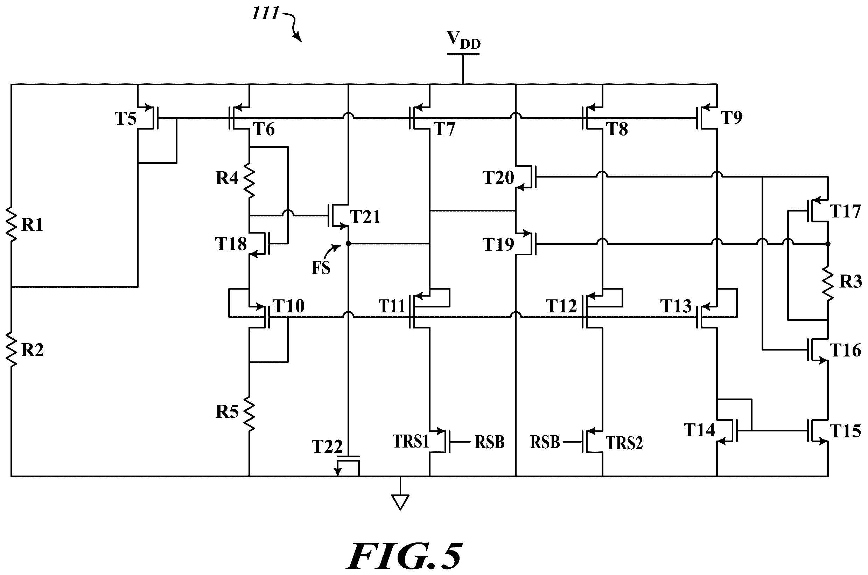

Figure 5 is a diagram of a floating supply generation circuit 111, in accordance with one embodiment. The floating supply generation circuit 111 can be part of the floating rail generation circuit 108 described in relation to Figure 1. The floating supply generation circuit 111 as shown in Figure 5 includes a plurality of transistors and resistors that share the same labels as the transistors and resistors shown in relation to the floating ground generation circuit 109 of Figure 2. However, in practice, the transistors and resistors of Figure 5 are separate components from the transistors and resistors of Figure 2.

The floating supply generation circuit 111 includes P-type transistors T5-T9 coupled together in a current mirror configuration. More particularly, the transistors T6-T9 drive mirrored currents based on the current through the transistor T5. The gate terminal of the transistor T5 is coupled to the drain terminal of the transistor T5. The drain terminal of the transistor T5 is coupled between the resistors R1 and R2. The resistors R1 and R2 are coupled in series between VDD and ground. The resistors R1 and R2 provide a threshold voltage to the drain terminal of the transistor T5. The source terminals of the transistors T5-T9 are coupled to VDD. In this manner, the threshold voltage from R1 and R2 drives the current through the transistors T5-T9.

The floating supply generation circuit 111 also includes P-type transistors T10-13, coupled together in a current mirror configuration. The transistor T10, in conjunction with the resistor R5 drives the current through the transistors T11-T13. In one embodiment, the resistor R5 has a value equal to the parallel resistance of R1 and R2. In one embodiment, the resistance of the resistor R5 is a threshold resistance.

The floating supply generation circuit 111 includes N-type transistor T14, T15, and T16, and P-type transistor T17. A resistor R3 is coupled between the drain terminals of the transistors T16 and T17. The source terminal of the transistor T14 is coupled to ground. The drain terminal of the transistor T14 is coupled to the gate terminal of the transistor T14 and to the drain terminal of the transistor T13. The transistor T14 is coupled in a current mirror configuration with the transistor T15. The transistor T16 has a source terminal coupled to the drain terminal of the transistor T15 and a gate terminal coupled to the source terminal of the transistor T17. The gate terminal of the transistor T17 is coupled to the drain terminal of the transistor T16.

The floating supply generation circuit 111 includes N-type transistors T18, T20, and T21, and P-type transistor T19. The source terminal of the transistor T18 is coupled to the source terminal of the transistor T10. A resistor R4 is coupled between the drain terminals of the transistors T18 and T6. The gate terminal of the transistor T18 is coupled to the drain terminal of the transistor T6. The source terminal of the transistor T19 is coupled to the source terminal of the transistor T20, the gate terminal is coupled to the source terminal of the transistor T17, and the drain terminal is coupled to ground. The drain terminal of the transistor T20 is coupled to VDD and the gate terminal is coupled to the drain terminal of the transistor T17. The source terminal of the transistor T21 is coupled to the source terminal of the transistor T11, the gate terminal is coupled to the drain terminal of the transistor T18, and the drain terminal is coupled to VDD.

The floating supply generation circuit 111 includes an N-type transistor T22 having source and drain terminals coupled to ground and agate terminal coupled to the node at which FS is generated. Accordingly, the transistor T22 is coupled as a capacitor having a first terminal corresponding to the gate and a second terminal corresponding to the body.

The floating supply voltage FS is generated at a node coupled to the gate terminals of the transistors T19, T20, to the source terminals of the transistors T11 and T21, and to the gate of the capacitor coupled transistor T22. Accordingly, the floating supply node is coupled to a gate terminal of both a P-type and an N-type transistor, and to a source terminal of both a P-type and an N-type transistor.

The floating supply generation circuit 111 includes a first range selection transistor TRS1. The first range selection transistor TRS1 is a P-type transistor having a drain terminal coupled to ground and a drain terminal coupled to the drain terminal of the transistor T11. The first range selection transistor TRS1 receives the range selection signal RSB on its gate terminal.

The floating supply generation circuit 111 includes a second range selection transistor TRS2. The second range selection transistor TRS2 is a P-type transistor having a drain terminal coupled to ground and a source terminal coupled to the drain terminal of the transistor T12. The second range selection transistor TRS2 receives the range selection signal RSB on its gate terminal.

The value of floating supply voltage FS is based on the range selection signal RSB. As will be described further below, the range selection signal RSB is based on the value of VDD. The effect of the floating supply generation circuit 111 is to generate the floating supply voltage FS as either VDD, or a high divided voltage, based on the range selection signal RSB. In particular, floating supply voltage FS is equal to VDD if VDD is less than the range selection voltage. FS is equal to the high divided voltage if VDD is greater than the range selection voltage.

In one embodiment, the high divided voltage is equal to VDD*((R2/(R1+R2)). Other values of the low divided voltage can be utilized without departing from the scope of the present disclosure.

The function of the circuit FS is similar to the function of the circuit of Figure 2, except that floating supply voltage FS is generated as the high divided voltage when the value of VDD is greater than the threshold. Floating supply voltage FS is generated as VDD if VDD is less than the threshold.

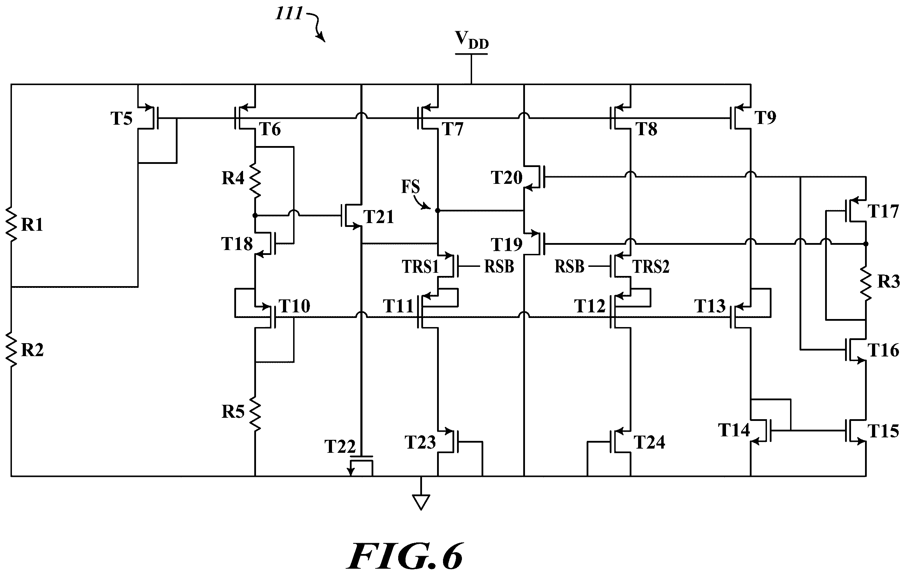

Figure 6 is a schematic diagram of a floating supply generation circuit 111, in accordance with one embodiment. The floating supply generation circuit 111 of Figure 6 is substantially similar to the floating supply generation circuit 111 of Figure 5. However, in Figure 6, the range selection transistor TRS1 has a drain terminal coupled to the source terminal of the transistor T11, and a source terminal coupled to the floating supply node. Accordingly, the floating supply voltage FS is generated at the source terminal of the range selection transistor TRS1. Additionally, the range selection transistor TRS2 has a drain terminal coupled to the source terminal of the transistor T12, and a source terminal coupled to the drain terminal of the transistor T8 and to the gate terminal of the transistor T19.

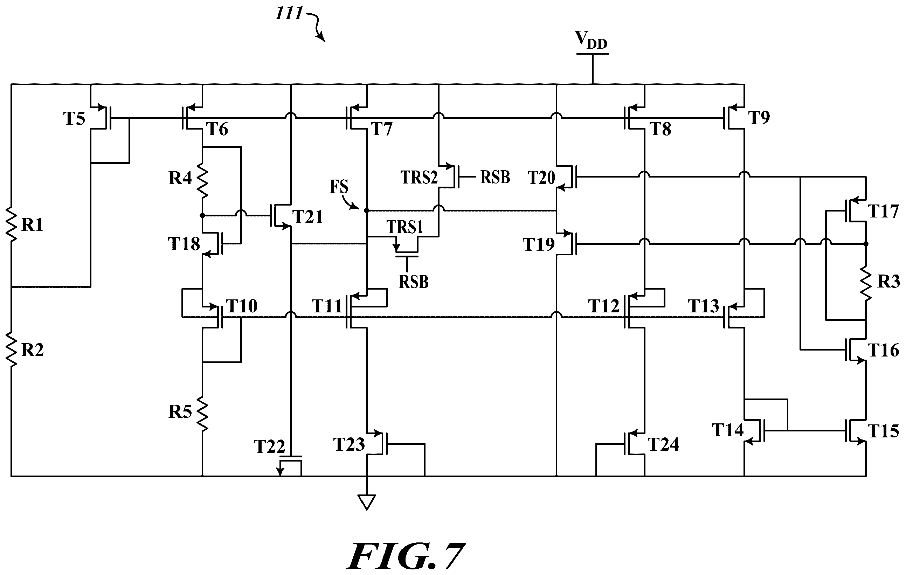

In Figure 6, a P-type transistor T23 has drain and gate terminals coupled to ground, and a source terminal coupled to the drain terminal of the transistor T11. A P-type transistor T24 has drain and gate terminals coupled to ground and a source terminal coupled to the drain terminal of the transistor T12. The effect of the floating supply generation circuit 111 of Figure 6 is to generate the floating supply voltage FS as either VDD, or a high divided voltage, based on the range selection signal RSB. In particular, FS is equal to VDD if VDD is less than the range selection voltage. FS is equal to the high divided voltage if VDD is greater than the range selection voltage. Figure 7 is a diagram exemplary of a floating supply generation circuit 111, in accordance with one embodiment. The floating supply generation circuit 111 of Figure 7 is substantially similar to the floating supply generation circuit 111 of Figure 6. However, in Figure 7, the range selection transistor TRS1 has a source terminal coupled to the source terminal of the transistor T11, and a drain terminal coupled to the drain terminal of the TRS2. Additionally, the range selection transistor TRS2 has a drain terminal coupled to the drain terminal of the range selection transistor TRS1, and a source terminal coupled to VDD. Accordingly, the floating supply voltage FS is generated at the source terminal of the range selection transistor TRS1. Furthermore, the gate terminals of the range selection transistors TRS1 and TRS2 receive the range selection signal RSB.

The effect of the floating supply generation circuit 111 of Figure 7 is to generate the floating supply voltage FS as either VDD or a high divided voltage, based on the range selection signal RSB. In particular, FS is equal to VDD if VDD is less than the range selection voltage. FS is equal to the high divided voltage if VDD is greater than the range selection voltage.

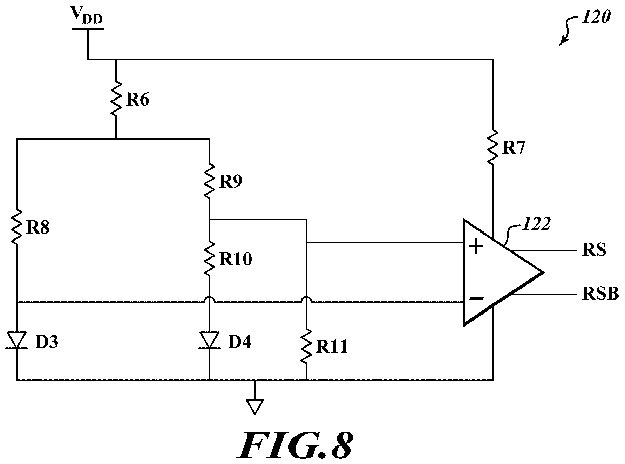

Figure 8 is a diagram exemplary of the range selection generator 120, in accordance with one embodiment. The range selection generator 120 includes a resistor R6 coupled to VDD. A resistor R7 is coupled between VDD and a high supply terminal of a comparator 122. A resistor R9 is coupled between the resistor R6 and a noninverting input of the comparator 122. A resistor R8 is coupled between the resistor R6 and the diode D3. The diode D3 is coupled between the resistor R8 and ground. The inverting input of the comparator 122 is coupled between R8 and D3. A resistor R10 is coupled between the resistor R9 and a diode D4. The diode D4 is coupled between the resistor R10 and ground. A resistor R11 is coupled between the resistor R9 and ground. A low supply terminal of the comparator 122 is coupled to ground.

The effect of the range selection generator 120 is to generate the range selection signals RS and RSB. The range selection signal RSB is the logical complement of the range selection signal RS. RS is high in VDD is greater than a range selection voltage. More particularly, RS is high and RSB is low if the voltage between the resistors R9 and R10 is greater than the voltage between the resistor R8 and the diode D3. RS is low and RSB is high if the VDD is less than the range selection voltage. More particularly, RS is low and RSB is high if the voltage between the resistors R9 and R10 is lower than the voltage between the resistor R8 and the diode D3.

In one embodiment, the range selection generator 120 detects the level of the supply voltage VDD and a defined threshold that is temperature compensated. Furthermore, because the differential signal is utilized for detection, the impact of diode process variations is reduced.

In one embodiment, when VDD is ramping up and is less than the forward bias voltage of the diode D3, current does not flow through R8. The inverting input will be following VDD and the non-inverting input will be lower than VDD. After VDD has crossed the forward bias voltage, the inverting input will have the value of the diode forward bias voltage. The non-inverting input will rise, but with a lower slope as current will also flow through D4 and R10. But if VDD continues to rise, eventually the non-inverting input will cross the threshold voltage and RS will go high. Accordingly, the values of the resistors R6-R11 are selected to provide a specified threshold voltage.

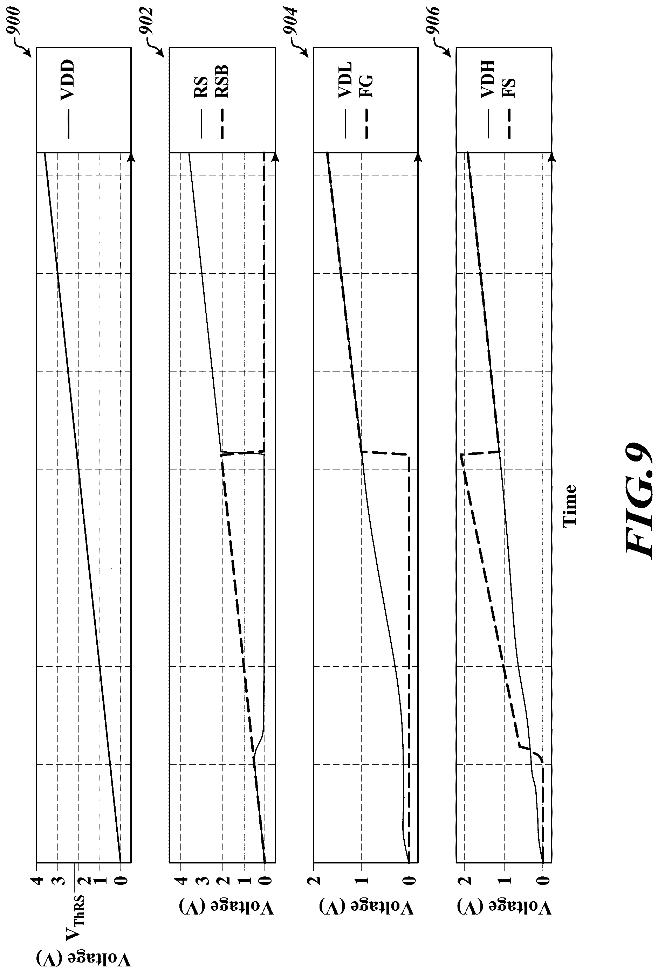

Figure 9 includes a plurality of plots or graphs related to the generation of the floating gate and floating supply voltages, in accordance with one embodiment. The graph 900 illustrates the value of the supply voltage VDD (ordinate axis) versus time (abscissa axis). The graph 900 is utilized to illustrate what happens to the range selection signals RS/RB in graph 902, the floating ground voltage FG and the low divided voltage VDL in the graph 904, and floating supply voltage FS and the high divided voltage VDH in the graph 906. In the graph 900, VDD changes from between 0 V and about 3.6 V. A range selection threshold Vthrs is about 2.2 V, for instance.

In the graph 902, while VDD is less than the range selection threshold Vthrs, RS is low. When VDD crosses the range selection threshold Vthrs, RS goes high and tracks VDD. When VDD is less than the range selection voltage Vthrs, RSB tracks VDD. When VDD crosses the range selection threshold Vthrs, RSB goes low.

In the graph 904, floating ground voltage FG remains at ground while VDD is less than the range selection threshold Vthrs. Floating ground voltage FG goes to the low divided voltage VDL when VDD exceeds the range selection threshold Vthrs. The low divided voltage tracks VDD, but with a lower magnitude.

In the graph 906, floating supply voltage FS remains has the value of VDD, while VDD is less than the range selection threshold Vthrs. Floating supply voltage FS goes to the high divided voltage VDH when VDD exceeds the range selection threshold Vthrs. The high divided voltage VDH tracks VDD, but with a lower magnitude.

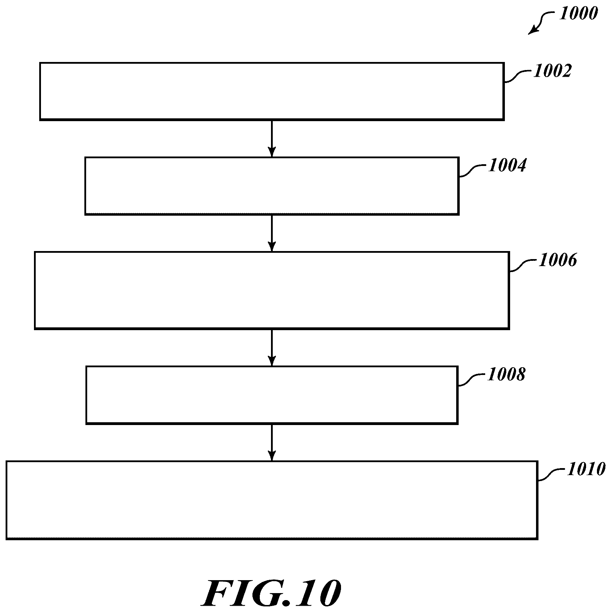

Figure 10 is a flow diagram exemplary of a method 1000 for operating an integrated circuit, in accordance with one embodiment. The method 1000 can utilize components, processes, and systems described in relation to Figures 1-9. At 1002, the method includes generating a range selection signal based on a comparison of a supply voltage to a threshold voltage. At 1004, the method includes receiving, with a floating ground generation circuit, the range selection signal. At 1006, the method includes outputting, with the floating ground generation circuit, either ground or a first divided voltage as a ground voltage based on a value of the range selection signal. At 1008, the method includes receiving, with a floating supply generation circuit, the range selection signal. At 1010, the method includes outputting, with the floating supply generation circuit, either the supply voltage or a second divided voltage as a high supply voltage based on the value of the range selection signal.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method (1000), comprising:
generating (1002) a range selection signal (RS; RSB) based on a comparison of a supply voltage (VDD) to a threshold voltage (Vthrs);
receiving (1004), with a floating ground generation circuit (108; 109), the range selection signal (RS; RSB);
outputting (1006), with the floating ground generation circuit (108; 109), either ground or a first divided voltage as a ground voltage (FG) based on a value of the range selection signal (RS; RSB);
receiving (1008), with a floating supply generation circuit (108; 111), the range selection signal (RS; RSB); and
outputting (1010), with the floating supply generation circuit (108; 111), either the supply voltage (VDD) or a second divided voltage as a high supply voltage (FS) based on the value of the range selection signal (RS; RSB).

2. The method (1000) of claim 1, comprising outputting the floating ground voltage (FG) to a low-supply terminal of a P-driver (102).

3. The method (1000) of claim 2, comprising driving, with the P-driver (102), a gate terminal of a pull-up transistor (T1) coupled between the supply voltage (VDD) and an I/O terminal (110) of an integrated circuit (100).

4. The method (1000) of claim 3, comprising outputting the floating supply voltage (FS) to a high-supply terminal of an N-driver (104), preferably further comprising driving, with the N-driver (104), a gate terminal of a pull-down transistor (T3) coupled between ground and the I/O terminal (110).

5. The method (1000) of claim 1, comprising:
outputting the floating ground voltage (FG) as ground if the supply voltage (VDD) is less than the threshold voltage (Vthrs); and
outputting the floating ground voltage (FG) as the first divided voltage if the supply voltage is greater than the threshold voltage (Vthrs).

6. The method (1000) of claim 1, comprising:
outputting the supply voltage (VDD) as the floating supply voltage (FS) if the supply voltage (VDD) is less than the threshold voltage (Vthrs); and
outputting the second divided voltage as the floating supply voltage (FS) if the supply voltage (VDD) is greater than the threshold voltage (Vthrs.

7. The method (1000) of claim 1, comprising:
providing the range selection signal (RS; RSB) to a control terminal of a range selection transistor (TRS1, TRS2) of a floating ground generation circuit (108; 109); and
generating, with the floating ground generation circuit (108; 109), the floating ground voltage (FG) based on the range selection transistor (TRS1, TRS2).

8. The method (1000) of claim 1, comprising:
providing the range selection signal (RS; RSB) to a control terminal of a range selection transistor (TRS1, TRS2) of a floating supply generation circuit (108; 111); and
generating, with the floating supply generation circuit (108; 111), the floating supply voltage (FS) based on the range selection transistor (TRS1, TRS2).

9. The method (1000) of claim 1, comprising generating the range selection signal (RS) with a comparator (122) having a first input node (+) coupled to a first node of a resistor tree (R6, R7, R8, R9, R10, R11) and a second input node (-) coupled to a second node of the resistor tree (R6, R7, R8, R9, R10, R11), preferably comprising generating, with the comparator (122), a differential output (RS, RSB).

10. An integrated circuit (100), comprising:
at least one range selection generator (120) configured to generate a range selection signal (RS; RSB) based on a magnitude of a supply voltage (VDD); and
a floating ground generation circuit (108; 109) configured to receive the range selection signal (RS; RSB) and to output a floating ground voltage (FG) having a value of either ground or a first divided voltage greater than ground based on the range selection signal (RS; RSB), and
a first driver (102) configured to receive the floating ground voltage (FG) at a low supply terminal.

11. The integrated circuit (100) of claim 10, wherein the floating ground generation circuit (108; 109) includes a first range selection transistor (TRS1) configured to receive on a gate terminal the range selection signal (RS; RSB), preferably wherein the floating ground generation circuit (108; 109) includes a second range selection transistor (TRS2) configured to receive on a gate terminal the range selection signal (RS; RSB).

12. The integrated circuit (100) of claim 10, wherein the range selection generator (108; 109) is configured to generate the range selection signal (RS; RSB) based on a comparison (122) of the supply voltage (VDD) to a threshold voltage (Vthrs).

13. The integrated circuit (100) of claim 10, comprising:
a floating supply generation circuit (108; 111) configured to receive the range selection signal (RS; RSB) and to output a floating supply voltage (FS) having a value of either the supply voltage (VDD) or a second divided voltage greater less than the supply voltage (VDD) based on the range selection signal (RS; RSB); and
a second driver (104) configured to receive the floating ground voltage (FG) at a high supply terminal.

14. The integrated circuit (100) of claim 10, comprising
a supply terminal configured to output the supply voltage (VDD);
a ground terminal configured to output ground;
an I/O terminal (110);
a pull-up transistor (T1) coupled between the supply terminal (VDD) and the I/O terminal (110) and having a gate terminal coupled to an output of the first driver (102); and
a pull-down transistor (T3) coupled between the ground terminal and the I/O terminal (110) and having a gate terminal coupled to an output of the second driver (104).

15. An integrated circuit (100), comprising:
a floating rail generation circuit (108), including:
a first range selection transistor (TRS1) configured to receive, on a gate terminal a range selection signal (RS; RSB);
a second range selection transistor (TRS2) configured to receive, on a gate terminal, the range selection signal (RS; RSB);
a first floating voltage node (FS; FG) coupled between a first voltage rail (VDD) and a second voltage rail and configured to output, as a first floating rail voltage (FS; FG), either the first floating voltage rail or a divided voltage having a value between the first and second voltage rails based on the range selection signal (RS; RSB).

16. The integrated circuit of 15, wherein the floating rail generation circuit (108) includes:
a third range selection transistor configured to receive, on a gate terminal the range selection signal (RS; RSB);
a fourth range selection transistor configured to receive, on a gate terminal, the range selection signal (RS; RB);
a second floating voltage node (FG; FS) coupled between the first voltage rail and the second voltage rail and configured to output, as a second floating rail voltage (FG; FS), either the second floating voltage rail or a second divided voltage having a value between the first and second voltage rails based on the range selection signal (RS; RSB),
preferably wherein the integrated circuit comprises a range selection generator (120) configured to generate the range selection signal (RS; RSB) based on a comparison (122) of either the first voltage rail (VDD) or the second voltage rail to a threshold voltage (Vthrs).
